# EUROPEAN PATENT APPLICATION

(11) **EP 2 320 453 A1**
(43) Date of publication of application: **11.05.2011**
(21) Application number: 09290843.3
(22) Date of filing: 06.11.2009
(51) Int. Cl.: H01L 21/60

(54) **Sensor packaging**

(71) Applicant: NXP B.V., 5656 AG Eindhoven (NL)
(72) Inventor: Van Dal, Marcus Johannes Henricus, Redhill, Surrey RH1 1DL (GB); Hoofman, Romano, Redhill, Surrey RH1 1DL (GB); De Bruin, Emile, Redhill, Surrey RH1 1DL (GB); Kamphuis, Tonny, Redhill, Surrey RH1 1DL (GB); Beelen-Hendrikx, Caroline Catherina Maria, Redhill, Surrey RH1 1DL (GB); Tak, Coen, Redhill, Surrey RH1 1DL (GB); Ponomarev, Youri Victorovitch, Redhill, Surrey RH1 1DL (GB); Daamen, Roel, Redhill, Surrey RH1 1DL (GB); Humbert, Aurelie, Redhill, Surrey RH1 1DL (GB)
(74) Representative: Hardingham, Christopher Mark

(57) **Abstract**

A sensor package comprising: an integrated circuit chip (4) having a first face (7) on which is provided a sensor (8) and a plurality of electrical contacts (5); a substrate (1) having a first face (11) on which an electrically conductive trace pattern (2) is formed, the first face (7) of the chip (4) being bonded to the first face (11) of the substrate (1) with an adhesive layer (3) such that the electrical contacts (5) connect with the electrically conductive trace pattern (2) and the sensor (8) is disposed over an aperture (12) provided in the substrate (1); and a frame (9) disposed between the first face (11) of the substrate (1) and the first face (7) of the chip (4), the frame (9) surrounding the sensor (8) and separating the sensor (8) from the plurality of electrical contacts (5).

## Description

The invention relates to sensor packaging solutions, and in particular to packaging of IC chips having an integrated sensing capability, for example for use in RFID tags.

In conventional methods of manufacturing RFID (Radio Frequency Identification) tags, an integrated circuit (IC) chip is mounted on a substrate on which conductive tracks are formed. The substrate may, among other things, provide the IC chip with an aerial that allows the tag to be powered by and communicate wirelessly with a remote device.

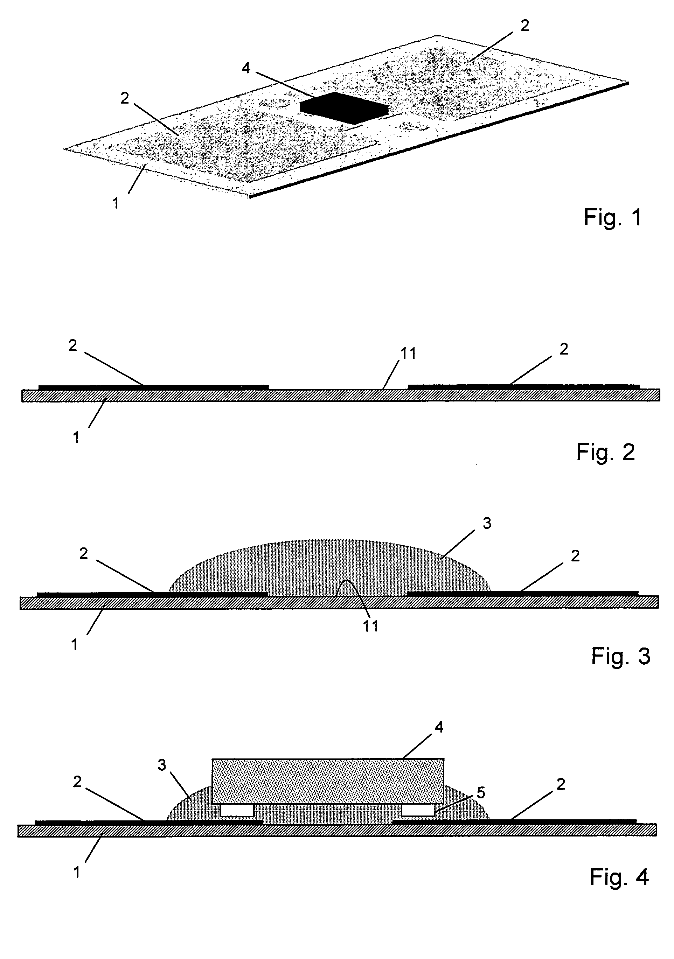

To allow for an easier interface with an antenna, the IC chip may be mounted on an additional substrate, typically known as an interposer, which provides larger scale connection pads for interfacing with an antenna. An IC chip 4 in place on such an interposer substrate 1, having connection pads 2 in the form of deposited metallic tracks is illustrated schematically in figure 1.

A typical method of assembling the chip and interposer substrate assembly using flip-chip packaging technology is illustrated in figures 2 to 7. As shown in cross-sectional view in figure 2, the substrate 1 comprises metallic tracks 2 deposited and etched on a first surface 11. The substrate 1 may, for example, be in the form of a PET (polyethylene terephthalate) foil with an etched aluminium or copper layer. Typical dimensions are 38 or 50µm for the foil thickness, with a 20µm thick Al layer or a 12µm thick Cu layer, or alternatively a 1µm vapour-deposited Cu layer.

In figure 3, an anisotropic conductive paste (ACP) 3 is applied over the surface 11 of the substrate 1, covering connecting portions of the metallic tracks 2. The ACP may be applied by jetting. A typical ACP comprises a hardenable resin containing a dispersion of small conductive particles, for example in the form of 1-2µm diameter nickel spheres.

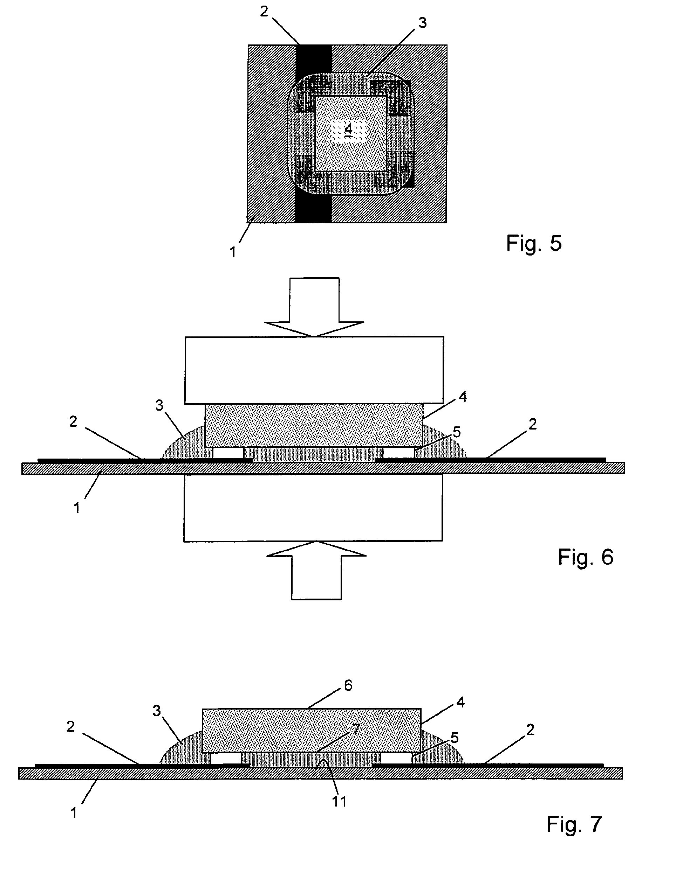

In figure 4 an IC chip, or die, 4 is then placed in the ACP layer 3, with electrical contacts 5 provided on a surface of the chip 4 aligned with corresponding connecting portions of the metallic tracks 2 on the substrate 1. Conductive particles in the ACP are caught between the electrical contacts 5 and metallic tracks 2. The alignment of the chip 4 is further illustrated in plan view in figure 5.

In figure 6, the chip 4 and substrate 1 is then subjected to pressure and temperature in order to form secure electrical connections between the contacts 5 and the metallic tracks 2 and to cure the ACP, thereby also mechanically securing the chip 4 to the substrate 1. The ACP is typically cured by applying pressure through the thickness of the chip 4 and substrate 1 at approximately 170°C for a short period of time, for example around 8 seconds. Figure 7 illustrates the resulting package, with the chip 4 secured to the first face 11 of the substrate 1 by the cured ACP layer 3. A first face 7 of the chip 4 is entirely covered by the ACP layer 3, while a second opposing face 6 is exposed. Since the chip 4 is applied to the substrate by a flip-chip process, all of the active components of the chip are covered by the ACP. No active components are present on the second face 7.

The arrangement illustrated in figure 7 results in a problem when attempting to incorporate sensor technology into such packages. Sensors configured to detect variations in environmental parameters such as light, humidity or other gas or liquid concentrations, will need to be exposed to the external environment within which the package is to be used. Incorporating such sensors as additional components separate from the IC chip is possible, but adds to the cost and processing of the overall package. A better solution would be to incorporate such a sensor into the chip 4 itself. The ACP layer 3, however, would prevent such a sensor from properly sensing the desired environmental parameter.

A further problem is that it may not be possible to apply the ACP layer 3 sufficiently accurately to avoid it impinging on a sensor that is incorporated into the chip 4, since the ACP material needs to be sufficiently fluid to flow at least around the contacts 5 of the chip to obtain a secure connection.

A further problem is how to ensure that a sensor incorporated into the chip is able to be sufficiently exposed to the desired environmental parameter to be measured.

It is an object of the invention to address one or more of the above mentioned problems.

In accordance with a first aspect of the invention there is provided a sensor package comprising:
an integrated circuit chip having a first face on which is provided a sensor and a plurality of electrical contacts;
a substrate having a first face on which an electrically conductive trace pattern is formed, the first face of the chip being bonded to the first face of the substrate with an adhesive layer such that the electrical contacts connect with the electrically conductive trace pattern and the sensor is disposed over an aperture provided in the substrate; and
a frame disposed between the first face of the substrate and the first face of the chip, the frame surrounding the sensor and separating the sensor from the plurality of electrical contacts.

An advantage of the invention is that the frame surrounding the sensor acts to prevent the adhesive from impinging on the sensor during assembly, thereby overcoming the problems associated with the adhesive layer flowing during and pressing and curing process. This ensures that sensor is exposed to the external environment through the aperture in the substrate.

The sensor package is preferably an RFID sensor package, for example in the form of a flip-chip strap package.

The frame is optionally in the form of a continuous ring surrounding the sensor.

The aperture may comprise a single hole of comparable size to the sensor or alternatively may be in the form of a plurality of holes in the substrate adjacent the sensor. Forming the aperture as a plurality of holes rather than a single larger hole can reduce the possibility of the sensor being affected by dirt and dust particles in the environment while the sensor package is in use.

The plurality of holes may be arranged in regular array, and the holes may be 100µm or smaller. Smaller holes will prevent a greater proportion of particles from passing through the aperture, the lower limit of hole size being largely limited by the manufacturing process used.

The plurality of holes may alternatively be in the form of porosity extending through the substrate material, thereby allowing the pores to be smaller than may be possible through a conventional manufacturing process such as laser drilling, while having a further advantage of removing a manufacturing step and relaxing the tolerances on positioning the sensor relative to the aperture.

In accordance with a second aspect of the invention there is provided a method of manufacturing a sensor package, the method comprising:
providing a substrate having a first face on which an electrically conductive trace pattern is formed;
applying an adhesive layer to the first face of the substrate to cover a portion of the trace pattern;
providing an integrated circuit chip having a first face on which is provided a sensor and a plurality of electrical contacts surrounding the sensor;
disposing a frame between the first face of the substrate and the first face of the chip, the frame laterally separating the sensor and the plurality of electrical contacts; and
bonding the first face of the chip to the first face of the substrate with the adhesive layer such that the plurality of electrical contacts connect with the trace pattern and the sensor is disposed over an aperture provided in the substrate.

As with the first aspect of the invention, an advantage of the second aspect of the invention is the use of a frame between the first face of the substrate and the first face of the chip, which serves to separate the sensor from the contacts on the chip, thereby ensuring that the adhesive layer does not impinge on the sensor.

During the step of bonding the first face of the chip to the first face of the substrate, the frame preferably provides a barrier that prevents the adhesive layer from flowing laterally past the frame towards the sensor.

The aperture is optionally formed in the substrate prior to the step of bonding the first face of the chip to the first face of the substrate.

The aperture may alternatively be formed in the substrate after the step of bonding the first face of the chip to the first face of the substrate.

The aperture may be formed by laser drilling, or by punching.

In accordance with a third aspect of the invention there is provided a sensor package comprising:
an integrated circuit chip having a first face on which is provided a sensor and a plurality of electrical contacts; and
a substrate having a first face on which an electrically conductive trace pattern is formed, the first face of the chip being bonded to the first face of the substrate with an adhesive layer such that the electrical contacts connect with the electrically conductive trace pattern and the sensor is disposed over an aperture provided in the substrate,
wherein the aperture comprises a plurality of holes in the substrate adjacent the sensor.

Embodiments of the present invention will now be described by way of example and with reference to the accompanying drawings in which:
figure 1 is a schematic perspective view of an IC chip in place on an interposer substrate;
figure 2 is a schematic cross-section of a substrate having metallic tracks on a first face;
figure 3 is a schematic cross-section of the substrate of figure 1 after application of an adhesive layer;
figure 4 is a schematic cross-section of the substrate of figure 2 with an IC chip applied over the adhesive layer;
figure 5 is a schematic plan view of the substrate with IC chip of figure 4;
figure 6 is a schematic cross-section of the substrate with IC chip of figures 4 and 5 during a curing process;
figure 7 is a schematic cross-section of an assembly resulting from the processes illustrated in figures 2 to 6;
figure 8 is a schematic cross-section of a substrate as in figure 1, with an adhesive layer applied over a selected portion;
figure 9a is a schematic plan view of the substrate of figure 8, with the adhesive layer applied in a first type of arrangement;
figure 9b is a schematic plan view of the substrate of figure 8, with the adhesive layer applied in a second type of arrangement;
figure 10 is a schematic cross-section of a substrate as in figure 1, with an adhesive layer applied as a film over a selected portion of the substrate;
figure 11 is a schematic plan view of the substrate and adhesive film layer of figure 10;
figure 12 is a schematic cross-section of the substrate of figure 8, with an IC chip positioned over the adhesive layer;
figure 13 is a schematic cross-section of the substrate and chip assembly of figure 12 during a curing process;
figure 14 is a schematic cross-section of the substrate and chip assembly after curing, in which the substrate is being subjected to a drilling process;
figure 15 is a schematic cross-section of the assembly of figure 14 after the drilling process;
figure 16 is a schematic cross-section of the substrate of figure 1 undergoing a drilling process;
figure 17 is a schematic cross-section of the substrate of figure 16 after the drilling process;
figure 18 is a schematic cross-section of the substrate of figure 15 after application of an adhesive layer; and
figure 19 is a schematic cross-section of an alternative sensor assembly embodiment.

Figures 1 to 7 have already been described above in relation to the background to the invention.

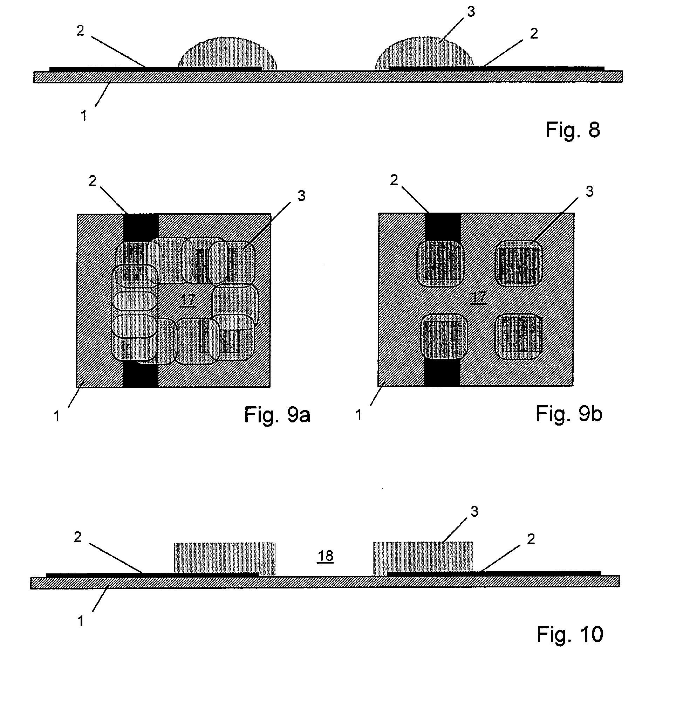

Figures 8 to 13 illustrate a manufacturing process according to the second aspect of the invention, the process resulting in an assembly according to the first aspect of the invention. As a first step, shown in figure 8, a substrate 1 having metallic tracks 2 is provided, which may be in a similar form to that of figure 2 described above. A layer of adhesive material, such as ACP, is then applied over selected portions of the substrate 1. An advantage of the ACP composition is that a more reliable electrical contact is formed due to the presence of conductive particles in the adhesive. A non-conductive adhesive layer may alternatively be used, provided this does not interfere with forming an electrical contact between the metallic tracks 2 and the electrical contacts 5. The adhesive layer 3 is applied over portions of the metallic tracks that provide electrical contacts with a flip-chip bonded IC chip (described below). The adhesive layer 3 may be provided, for example by means of a jetting process, in the form of a ring as shown in plan view in figure 9a, or alternatively in the form of separate islands covering the contact regions of the metallic tracks 2 as shown in figure 9b. In both cases, a central portion 17 of the substrate 1 between the contact regions is left with no adhesive layer to allow for a sensor on a chip placed over the substrate to be exposed to the external environment, provided an aperture is formed in the substrate 1 in the central region 17 at some point during the manufacturing process.

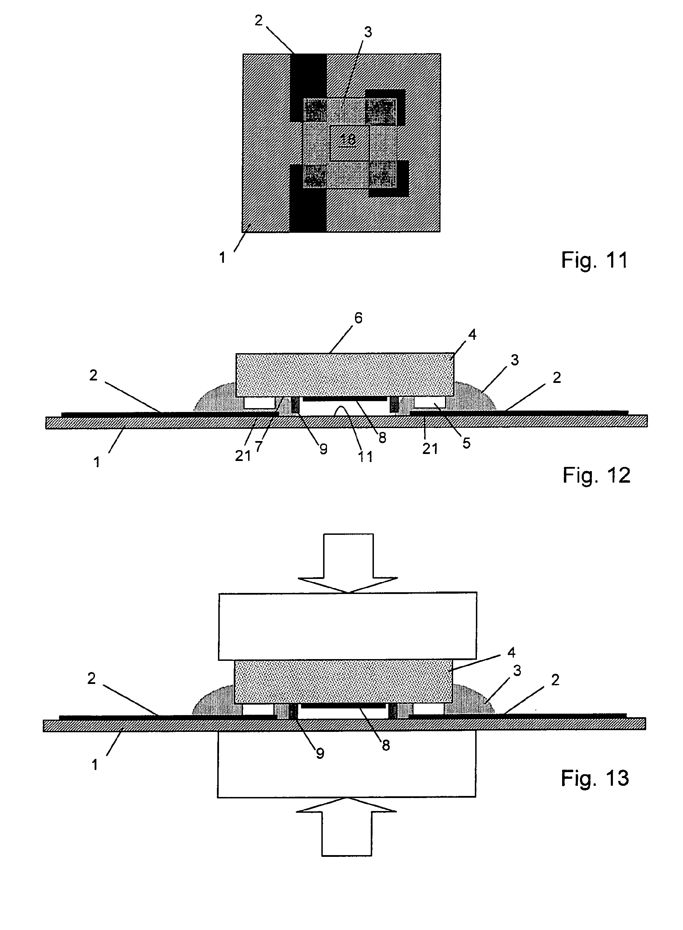

As an alternative to the adhesive layer being applied by jetting, the layer 3 may be applied in the form of a film, as shown in figure 10 and in plan view in figure 11, where the adhesive layer film is in the form of a ring with a central hole 18 for a sensor to be aligned within.

Figure 12 shows an IC chip 4 in place over the substrate 1 such that electrical contacts 5 on a first face 7 of the chip 4 are aligned with the contact regions 21 on the metallic tracks 2 on the substrate 1. A sensor area 8 is also provided on the first face 7 of the chip 4, the sensor 8 being positioned to avoid contact with the adhesive layer 3.

A dummy structure in the form of a frame 9 is provided between the first face 7 of the chip 4 and the first face 11 of the substrate 1, the frame 9 configured to form a barrier between the sensor area 8 and the adhesive layer 3. The frame 8 surrounds the sensor 8 and separates the sensor from the electrical contacts 5. The frame 8 may be in the form of a continuous ring that encompasses the sensor area, or alternatively may be in the form of a broken ring or series of structures that separate the sensor 8 from the electrical contacts 5 only where needed to prevent the adhesive material 3 from impinging on the sensor 8.

The gap between the first face 7 of the chip 4 and the first face 11 of the substrate 1 is determined by the height of the (typically four) balls forming the electrical contacts 5. These may typically vary between 30 and 250 µm in height, depending on the particular application method used (for example via electroplating or stud bumping).

Various different materials and methods may be used to apply the frame around the sensor area. Exemplary methods of forming the frame include: i) using a photoresist material such as SU-8 (a type of photosensitive epoxy resin); ii) depositing a metal or dielectric layer on the die, defined by lithography and etching processes; iii) soldering (for example using a Sn/Au composition) on a predefined metal pattern on the die (typically aluminum); and iv) stencil printing techniques, which may be used to deposit ceramic or metal compositions.

As in the process illustrated in figure 6 and described above, the chip 4 is then bonded to the substrate by the application of pressure and heat, illustrated in figure 13. Although the adhesive layer 3 will spread to some extent under the applied pressure, the frame 9 prevents the adhesive material from reaching the sensor 8.

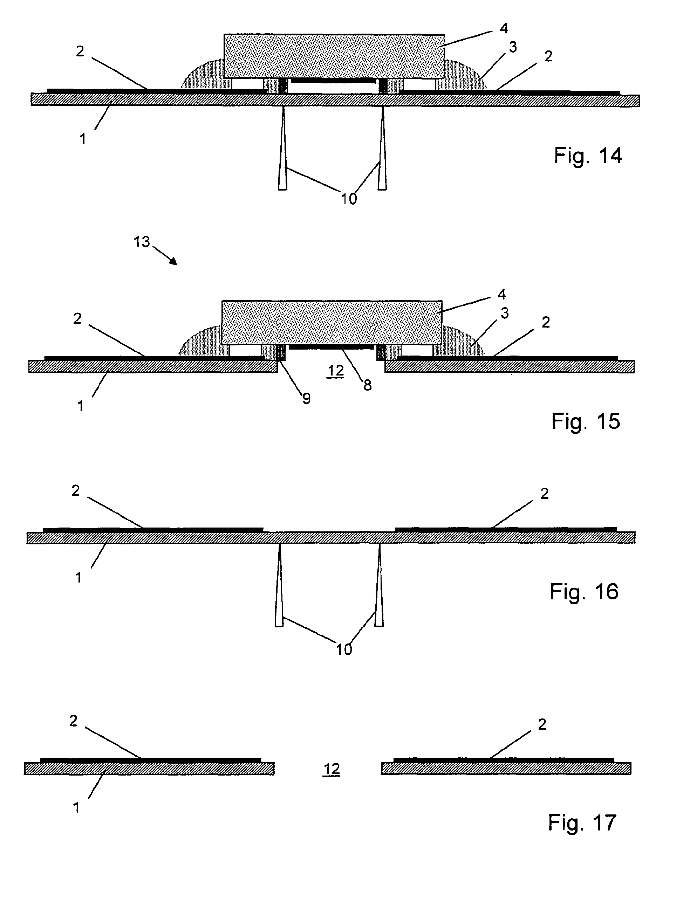

After the curing step, a drilling step is carried out to form an aperture in the substrate, to allow the sensor 8 to be exposed. This is illustrated in figure 14, in which a laser drilling beam 10 is used to cut an aperture in the substrate 1. The final form of the RFID sensor package 13 is shown in figure 15, in which the sensor 8 is disposed over an aperture 12 provided in the substrate 1 formed by the laser drilling step.

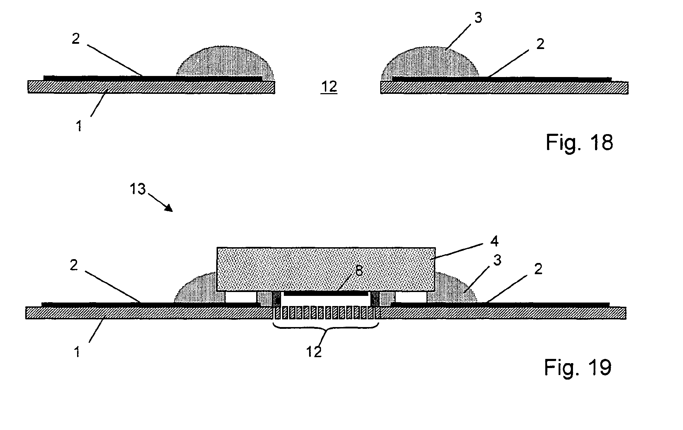

In an alternative method of arriving at the RFID sensor package 13 of figure 15, the aperture 12 may be formed in the substrate 1 prior to application of the adhesive layer. In this alternative, the aperture may optionally be formed by another method such as punching of the substrate, which would otherwise not be feasible when the chip 4 is in position. As in the process described above, the adhesive layer can be applied as either a continuous ring surrounding the aperture or as a discontinuous series of points over contact regions of the metallic tracks 2 on the first surface 11 of the substrate 1. The alternative method, using laser drilling, is illustrated in figures 16, 17 and 18, showing a sequence of processing steps including laser drilling (figure 16) to form the aperture (figure 17), followed by application of the adhesive layer 3 (figure 18) on the substrate 1 around the aperture 12.

In the above alternative method, the frame 9 may not be required, since any excess adhesive material is deflected from impinging on the sensor by the aperture. The frame would however be a preferred option to ensure the sensor remains clear.

As an illustrative embodiment, the aperture 12 formed in the substrate 1 may be around 600 µm in size, being for example in the form of a circular aperture. This size of aperture is large enough to encompass a typical sensor on an IC chip for use in an RFID tag package. One possible issue with such an aperture is that the aperture thereby formed is also large enough to allow contaminants such as dust particles to pass through and potentially interfere with the operation of the sensor, causing reliability and drift problems. In order to reduce this possibility, alternative embodiments may be provided with an aperture 12 in the form of a series of small holes in the substrate rather than a single large hole. This is illustrated in figure 19. The holes are preferably of a dimension that will allow the sensor 8 to detect the external environment, i.e. allowing sufficient air exchange or light diffusion across the substrate aperture 12, but sufficiently small to prevent dust particles from entering the internal volume 13 between the aperture 12 and the sensor 8. Preferable dimensions for the holes are 100 µm or smaller, and more preferably 50 µm or smaller.

The series of small holes making up the alternative aperture 12 in the embodiment of figure 19 may be formed by laser drilling individual holes through the substrate 1 either before or after the chip 4 is bonded to the substrate by means of the adhesive layer 3. The sizes achievable by conventional laser drilling techniques are typically within a range of 25 to 1000 µm in diameter, resulting in a preferred range of hole size for the aperture of between 25 and 100 µm, or between 25 and 50 µm. The series of holes are preferably in the form of a regular array covering at least the extent of the sensor 8.

In alternative embodiments the hole sizes in the substrate aperture could be considerably smaller, through the use of porosity that may be present in the substrate material itself (examples being PET, PTFE and polyimide among others), the size range of which can be chosen to enable diffusion of gases to and from the sensor area across the substrate. The choice of substrate material can therefore determine the sensitivity of the sensor, and in particular the response time, which is dependent on the rate of diffusion of gas through the substrate. In such alternative embodiments, the pore size may be considerably smaller than the range available through laser drilling, being generally less than 25 µm and typically less than 1µm, with a possible range extending to 100nm or smaller. In such embodiments, the aperture does not necessarily need to be accurately located relative to the sensor, since the substrate material is provided with porosity throughout.

Other embodiments are intentionally within the scope of the invention as defined by the appended claims.

## Claims

1. A sensor package comprising:
an integrated circuit chip (4) having a first face (7) on which is provided a sensor (8) and a plurality of electrical contacts (5);
a substrate (1) having a first face (11) on which an electrically conductive trace pattern (2) is formed, the first face (7) of the chip (4) being bonded to the first face (11) of the substrate (1) with an adhesive layer (3) such that the electrical contacts (5) connect with the electrically conductive trace pattern (2) and the sensor (8) is disposed over an aperture (12) provided in the substrate (1); and
a frame (9) disposed between the first face (11) of the substrate (1) and the first face (7) of the chip (4), the frame (9) surrounding the sensor (8) and separating the sensor (8) from the plurality of electrical contacts (5).

2. The sensor package of claim 1 wherein the frame (9) is in the form of a continuous ring surrounding the sensor (8).

3. The sensor package of claim 1 or claim 2 wherein the aperture (12) comprises a plurality of holes in the substrate adjacent the sensor (8).

4. The sensor package of claim 3 wherein the plurality of holes are arranged in regular array.

5. The sensor package of claim 3 wherein the plurality of holes are in the form of porosity extending through the substrate material.

6. The sensor package of any one of claims 3 to 5 wherein the plurality of holes are 100µm or smaller.

7. A method of manufacturing a sensor package (13), the method comprising:
providing a substrate (1) having a first face (11) on which an electrically conductive trace pattern (2) is formed;
applying an adhesive layer (3) to the first face (11) of the substrate (1) to cover a portion of the trace pattern (2);
providing an integrated circuit chip (4) having a first face (7) on which is provided a sensor (8) and a plurality of electrical contacts (5) surrounding the sensor (8);
disposing a frame (9) between the first face (11) of the substrate (1) and the first face (7) of the chip, the frame (9) laterally separating the sensor (8) and the plurality of electrical contacts (5); and
bonding the first face (7) of the chip (4) to the first face (11) of the substrate (1) with the adhesive layer (3) such that the plurality of electrical contacts (5) connect with the trace pattern (2) and the sensor (8) is disposed over an aperture (12) provided in the substrate (1).

8. The method of claim 7 wherein, during the step of bonding the first face (7) of the chip (4) to the first face (11) of the substrate (1), the frame (9) provides a barrier that prevents the adhesive layer (3) from flowing laterally past the frame (9) towards the sensor (8).

9. The method of claim 7 or claim 8 wherein the aperture (12) is formed in the substrate (1) prior to the step of bonding the first face (7) of the chip (4) to the first face (11) of the substrate (1).

10. The method of claim 7 or claim 8 wherein the aperture (12) is formed in the substrate after the step of bonding the first face (7) of the chip (4) to the first face (11) of the substrate (1).

11. The method of any one of claims 7 to 10 wherein the aperture (12) is formed by laser drilling.

12. The method of claim 9 wherein the aperture (12) is formed by punching.

13. The method of any one of claims 7 to 12 wherein the aperture comprises a plurality of holes in the substrate (1).

14. The method of claim 13 wherein the plurality of holes are arranged in a regular array.

15. The method of claim 13 or claim 14 wherein the plurality of holes are 100 µm or smaller.
